# FASCICULE DE BREVET EUROPEEN

(11) **EP 1 670 063 B1**
(45) Date de publication et mention de la délivrance du brevet: **01.08.2007**
(21) Numéro de dépôt: 05111773.7
(22) Date de dépôt: 07.12.2005
(51) Int. Cl.: H01L 29/872, H01L 29/41, H01L 21/329

(54) **Périphérie de composant unipolaire vertical**
Peripherie eines vertikalen, unipolaren Bauelementes
Vertical unipolar device periphery

(30) Priorité: 08.12.2004 FR 0452902
(43) Date de publication de la demande: 14.06.2006
(73) Titulaire: ST MICROELECTRONICS S.A., 92120 Montrouge (FR)
(72) Inventeur: LANOIS, Frédéric, 37100, TOURS (FR)
(74) Mandataire: de Beaumont, Michel

(56) Documents cités:
- WO-A-20/04008529
- DE-A1- 10 051 909

## Description

### Domaine de l'invention

La présente invention concerne les composants unipolaires verticaux et plus particulièrement la périphérie de tels composants.

### Exposé de l'art antérieur

La description suivante vise plus particulièrement, uniquement à titre d'exemple, le cas de composants de type diode Schottky réalisés sous forme verticale dans des substrats de silicium. Toutefois l'invention s'applique également à toute structure unipolaire verticale et à sa formation monolithique dans un substrat semiconducteur et notamment à la réalisation de transistors verticaux de type MOS ayant une plus faible résistance à l'état passant et une plus forte tension de claquage en inverse à l'état bloqué.

De façon classique une diode Schottky comporte un substrat semiconducteur fortement dopé, typiquement en silicium monocristallin. Une couche de cathode plus faiblement dopée que le substrat recouvre le substrat. Une couche métallique ou plus couramment un siliciure métallique forme un contact Schottky avec la cathode et constitue l'anode de la diode.

La réalisation de tels composants unipolaires se heurte à deux contraintes opposées. Ils doivent présenter une résistance à l'état passant (Ron) la plus petite possible tout en ayant une tension de claquage élevée. Minimiser la résistance à l'état passant impose de minimiser l'épaisseur de la couche la moins dopée et de maximiser le dopage de cette couche. Au contraire, pour obtenir une tension de claquage en inverse élevée, il faut minimiser le dopage de la couche la moins dopée et maximiser son épaisseur, tout en évitant de créer des zones dans lesquelles les équipotentielles sont fortement courbées.

On a proposé diverses solutions pour concilier ces contraintes opposées et on est arrivé à des structures de diodes Schottky à capacité MOS, couramment désignées par l'appellation TMBS, de l'expression anglaise Trench MOS Barrier Schottky. Dans un exemple de telles structures, des zones conductrices, par exemple en silicium polycristallin fortement dopé de type N, sont formées dans une partie supérieure d'une couche épaisse de cathode moins fortement dopée de type N qu'un substrat sous-jacent. Une couche isolante isole les zones conductrices de la couche épaisse. Une couche d'anode recouvre l'ensemble de la structure, contactant la surface supérieure des zones conductrices isolées et formant un contact Schottky avec la cathode.

En polarisation inverse, les zones conductrices isolées provoquent une déplétion latérale de la couche de cathode qui modifie la répartition des équipotentielles dans cette couche. Cela permet d'accroître le dopage de la couche de cathode, donc de réduire la résistance à l'état passant sans effet adverse sur la tension de claquage en inverse.

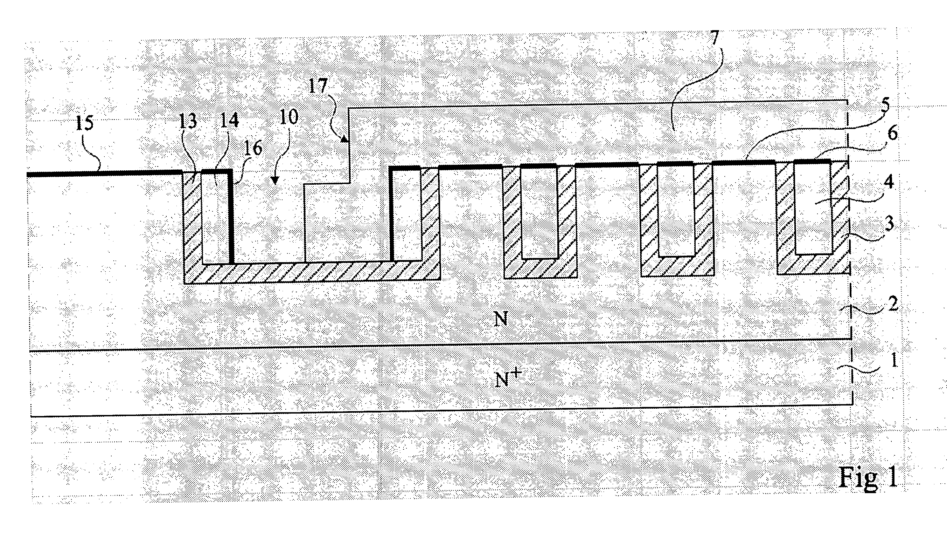

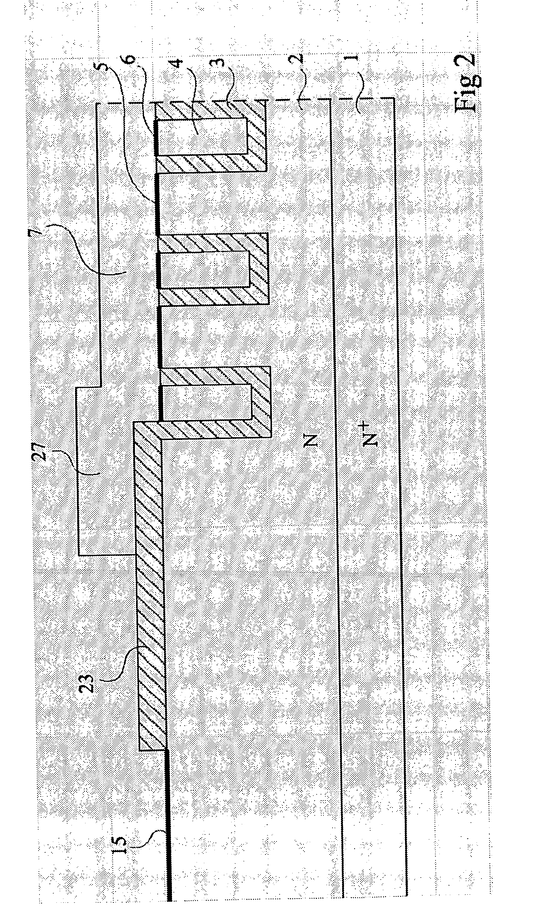

Les figures 1 et 2 sont des vues partielles d'exemples de diodes Schottky TMBS selon l'art antérieur. Dans ces deux figures, on a représenté du côté droit une partie du composant et du côté gauche la périphérie du composant destinée à assurer sa tenue en tension.

Dans ces deux figures, le composant représenté du côté droit est formé à partir d'une plaquette de silicium 1 fortement dopée de type N sur laquelle est formée une couche épitaxiale 2 faiblement dopée de type N. Dans cette couche épitaxiale, dans la zone correspondant au composant lui-même, sont formées des tranchées dont les parois sont revêtus d'une couche d'oxyde 3 et qui sont remplies de silicium polycristallin 4 dopé pour être conducteur. De façon classique, l'oxydation peut être une oxydation thermique et le remplissage de silicium polycristallin peut se faire par dépôt conforme, ces étapes de remplissage étant suivies d'une étape de planarisation. Après quoi, on dépose un métal, par exemple du nickel susceptible de former un siliciure 5 au-dessus des régions de silicium monocristallin et 6 au-dessus des zones de remplissage de silicium polycristallin. Une fois le siliciure formé, le métal n'ayant pas réagi avec le silicium est éliminé par gravure sélective. Après quoi, un dépôt métallique d'anode 7 est formé.

La figure 1 illustre un premier exemple de structure périphérique permettant l'étalement des lignes de champ et la tenue en tension du dispositif. Une telle structure est connue du document WO-A-2004/008529. Dans cet exemple, en même temps que les tranchées de la zone active, on creuse en périphérie une tranchée plus large 10. Les parois de la tranchée 10 sont revêtues d'un oxyde 13 et de silicium polycristallin 14 formés en même temps que l'oxyde 3 et le silicium polycristallin 4. Si le silicium polycristallin est déposé de façon conforme et que le silicium polycristallin en excès est éliminé par gravure anisotrope, il ne reste du silicium polycristallin 14 que sur les flancs de la tranchée 10. La formation de la périphérie ne nécessite donc pas d'étapes supplémentaires par rapport à la formation de la partie active de la diode. Lors de la formation du siliciure, des zones de siliciure se forment également sur la périphérie externe 15 du composant et sur les parois de silicium polycristallin 14 sur les bords de la tranchée pour fournir un siliciure 16. Ensuite, la couche métallique d'anode 7 est déposée et gravée pour qu'elle comprenne un prolongement qui s'arrête sensiblement au milieu de la tranchée large 10.

Ce procédé de réalisation de la structure de la figure 1, apparemment simple, présente néanmoins deux inconvénients. D'une part, il n'est pas facile de graver la couche de métal 7, par exemple de l'aluminium, au fond de la tranchée 10. D'autre part, dans un cas pratique où la tranchée a une profondeur de l'ordre de 3 à 10 µm et la couche de métal 7 a une épaisseur de l'ordre de 5 à 10 µm, il peut se produire que le métal se dépose mal sur les flancs 17 de la tranchée et se fissure. La continuité du métal entre la partie supérieure et le fond de la tranchée n'est alors plus assurée et le dispositif n'est pas opérationnel.

Un autre exemple de structure de protection périphérique selon l'art antérieur est représenté en figure 2. Cette fois-ci, la périphérie de la structure comprend une couche d'isolant, 23, formée par exemple en même temps que l'oxyde de silicium 2 des parois des tranchées. La métallisation 7 comprend un prolongement 27 qui recouvre partiellement cette couche d'isolement. Cette structure fonctionne mais nécessite un niveau de masque supplémentaire pour délimiter la couche d'isolement 23.

Par ailleurs, le document DE-A-10051909 décrit une structure périphérique à tranchée multiple formée dans une zone isolante.

Ainsi, un objet de la présente invention est de prévoir une structure de périphérie d'un composant de type TMBS qui pallie les inconvénients de l'art antérieur.

### Résumé de l'invention

Selon la revendication 1, pour atteindre cet objet, la présente invention prévoit un composant unipolaire vertical formé dans un substrat semiconducteur, comprenant des doigts verticaux en un matériau conducteur entourés d'oxyde de silicium, des portions du substrat étant présentes entre les doigts et l'ensemble étant revêtu d'une couche conductrice. La périphérie du composant comprend une succession de doigts disposés dans des tranchées concentriques, séparées les unes des autres seulement par de l'oxyde de silicium, la surface supérieure des doigts d'au moins la rangée la plus interne étant en contact avec ladite couche conductrice.

Selon un mode de réalisation de la présente invention, les tranchées internes parmi les tranchées concentriques sont reliées entre elles par des premiers doigts conducteurs transverses, de même que les tranchées externes par des seconds doigts conducteurs transverses, les tranchées internes étant destinées à être liées à ladite couche conductrice.

Selon la revendication 3, la présente invention vise aussi un procédé de fabrication d'un tel composant unipolaire vertical dans un substrat semiconducteur, comprenant les étapes consistant à former dans le substrat semiconducteur des premières tranchées espacées d'une première distance dans la zone correspondant au composant unipolaire proprement dit et des secondes tranchées périphériques espacées d'une seconde distance inférieure à la première distance à la périphérie du composant, et procéder à une oxydation thermique de sorte qu'il se forme une paroi périphérique d'oxyde de silicium entre les premières tranchées et que les portions du substrat semiconducteur entre les secondes tranchées sont complètement oxydées en oxyde de silicium.

### Brève description des dessins

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :
la figure 1 est une vue en coupe d'un composant de type TMBS et de sa périphérie selon un premier exemple de l'art antérieur ;
la figure 2 est une vue en coupe d'un composant de type TMBS et de sa périphérie selon un deuxième exemple de l'art antérieur ;
la figure 3 est une vue en coupe d'un composant TMBS et de sa périphérie selon un mode de réalisation de la présente invention ;
la figure 4 est une vue de dessus partielle correspondant à la vue en coupe de la figure 3 ; et
les figures 5A et 5B illustrent des étapes de réalisation de la structure de la figure 3.

### Description détaillée

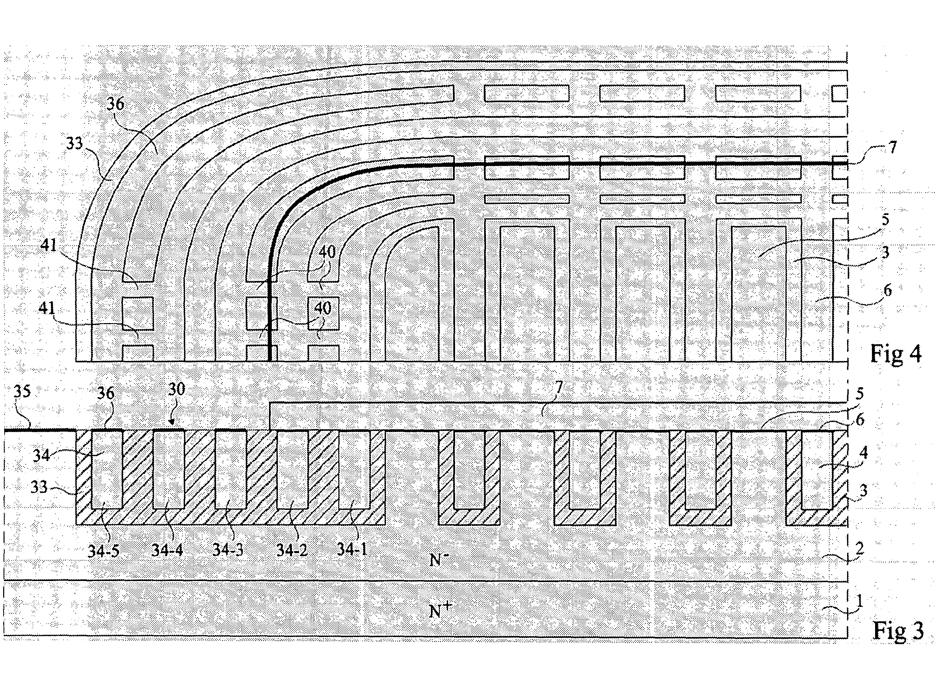

En figure 3, on a à nouveau représenté dans la partie droite un composant TMBS avec les mêmes références qu'en figures 1 et 2, à savoir que l'on retrouve le substrat de silicium 1, la couche épitaxiale 2 faiblement dopée de type N, la couche d'oxyde 3, le silicium polycristallin conducteur 4, les zones de siliciure 5 et 6, et l'anode 7.

A la périphérie du composant, en même temps que l'on a formé les tranchées dans lesquelles sont formés les doigts conducteurs 4 entourés d'un oxyde 3, on forme une succession de tranchées 30 très rapprochées les unes des autres. L'oxyde 3 est formé par oxydation thermique de sorte que, lors de l'oxydation, les portions du substrat semiconducteur comprises entre les tranchées rapprochées 30 de la périphérie sont complètement transformées en un oxyde 33. Ainsi, on obtient, en périphérie, des doigts de silicium polycristallin conducteur 34 complètement isolés les uns des autres, comme s'ils étaient formés dans un caisson isolant, sans portion de silicium entre eux. Comme précédemment, ces doigts conducteurs 34 sont revêtus d'un siliciure 36 qui se forme en même temps que le siliciure 6 et la périphérie est revêtue d'un siliciure 35 formé en même temps que ce siliciure 6 et le siliciure 5 de contact Schottky sur la partie semiconductrice dans la partie active de la diode.

La métallisation 7 se prolonge sur au moins le premier doigt conducteur et de préférence sur plusieurs, par exemple deux, comme cela est illustré dans la figure. Les divers doigts conducteurs sont désignés en figure 3 par les références 34-1, 34-2, 34-3, 34-4 et 34-5. Comme cela est représenté en vue de dessus en figure 4, ces doigts conducteurs 34 ont la forme de tranchées périphériques entourant tout le composant. Comme l'illustre la vue de dessus de la figure 4, il est de préférence prévu des doigts conducteurs transverses 40 qui relient les tranchées périphériques internes (par exemple les trois premières) et des doigts conducteurs transverses 41 qui relient les tranchées périphériques externes (par exemple les trois dernières). Ainsi, même si la métallisation supérieure 7 est définie avec une mauvaise précision par rapport au pas des tranchées périphériques, un nombre déterminé de tranchées périphériques est au potentiel de la métallisation d'anode 7.

Les autres parties de la vue de dessus de la figure 4 se comprennent d'elle-même, de mêmes éléments étant désignés par de mêmes références qu'en figure 3.

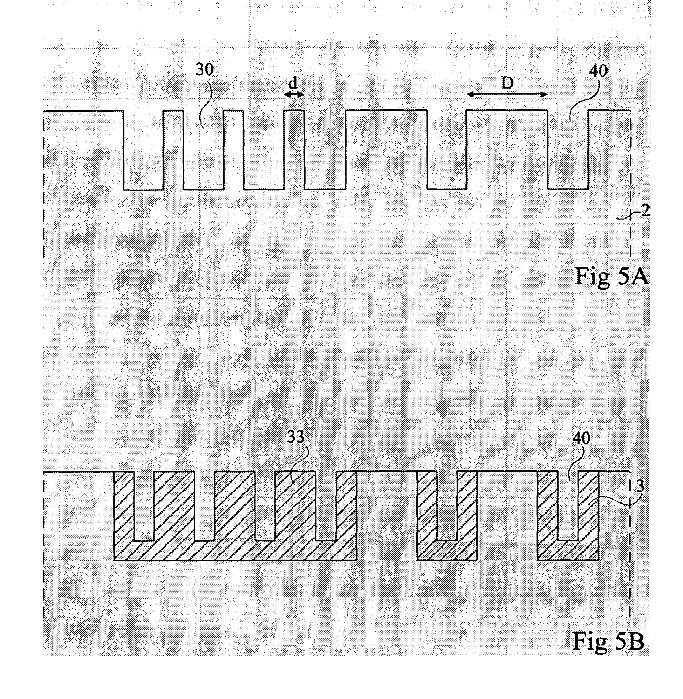

Les figures 5A et 5B illustrent plus en détail des étapes de réalisation de la structure des figures 3 et 4.

Comme l'illustre la figure 5A, dans une étape initiale, on forme dans la couche épitaxiale 2 des tranchées espacées 40 dans la zone de la diode TMBS proprement dite et des tranchées 30 dans la zone périphérique. Les tranchées 40 sont espacées d'une distance D et les tranchées 30 d'une distance d inférieure à la distance D.

Comme l'illustre la figure 5B, à l'étape suivante, on procède à une oxydation thermique qui est réalisée de sorte que les espaces d entre tranchées 30 se transforment complètement en oxyde de silicium. Dans la figure, on a représenté schématiquement que l'oxydation thermique produit un développement d'oxyde à l'intérieur de silicium sensiblement de même épaisseur que le développement d'oxyde à partir de la paroi de silicium. En pratique, le rapport entre les épaisseurs d'oxyde formées à l'intérieur du silicium et à l'extérieur du silicium initial est de l'ordre de 0,85 à 1 (46% à l'intérieur du silicium, 50% à l'extérieur du silicium). L'homme de l'art saura choisir la valeur de la distance d entre tranchées 30 et la durée d'oxydation pour obtenir l'oxydation complète illustrée en figure 5B.

Lors des étapes suivantes, on procède de la façon décrite précédemment au remplissage des tranchées par des doigts conducteurs, couramment en silicium polycristallin, à la formation d'un contact Schottky, et au dépôt d'une métallisation d'anode.

La présente invention est susceptible de diverses variantes et modifications qui apparaîtront à l'homme de l'art, dans les limites définies par les revendications, notamment en ce qui concerne les divers matériaux utilisés. L'aspect essentiel de l'invention réside dans la structure périphérique et son procédé d'obtention qui consiste à former des tranchées minces dans lesquelles une oxydation thermique est réalisée pour que le silicium entre les tranchées soit transformé en oxyde de silicium.

## Revendications

1. Composant unipolaire vertical formé dans un substrat semiconducteur, comprenant des doigts verticaux (4) en un matériau conducteur entourés d'oxyde de silicium (3), des portions du substrat (2) étant présentes entre les doigts et l'ensemble étant revêtu d'une couche conductrice (7), **caractérisé en ce que** la périphérie du composant comprend une succession de doigts (34-1 à 34-5) disposés dans des tranchées concentriques, séparées les unes des autres seulement par de l'oxyde de silicium (33), la surface supérieure des doigts d'au moins la rangée la plus interne (34-1) étant en contact avec ladite couche conductrice.

2. Composant selon la revendication 1, **caractérisé en ce que** les tranchées internes parmi les tranchées concentriques sont reliées entre elles par des premiers doigts conducteurs transverses (40), de même que les tranchées externes par des seconds doigts conducteurs transverses (41), les tranchées internes étant destinées à être liées à ladite couche conductrice (7).

3. Procédé de fabrication d'un composant unipolaire vertical dans un substrat semiconducteur selon la revendication 1, **caractérisé en ce qu'**il comprend les étapes suivantes :
former dans le substrat semiconducteur des premières tranchées (40) espacées d'une première distance (D) dans la zone correspondant au composant unipolaire proprement dit et des secondes tranchées périphériques (30) espacées d'une seconde distance (d) inférieure à la première distance (D) à la périphérie du composant, et
procéder à une oxydation thermique de sorte qu'il se forme une paroi périphérique d'oxyde de silicium (3) entre les premières tranchées et que les portions du substrat semiconducteur entre les secondes tranchées sont complètement oxydées en oxyde de silicium (33).

## Claims

1. A vertical unipolar component formed in a semiconductor substrate, comprising vertical fingers (4) made of a conductive material surrounded with silicon oxide (3), portions of the substrate (2) being present between the fingers and the assembly being coated with a conductive layer (7), **characterized in that** the component periphery comprises a succession of fingers (34-1 to 34-5) arranged in concentric trenches, separated from one another by silicon oxide (33) only, the upper surface of the fingers of at least the innermost rank (34-1) being in contact with said conductive layer.

2. The component of claim 1, **characterized in that** the internal trenches among the concentric trenches are interconnected by first transverse conductive fingers(40), and the external trenches are likewise interconnected by second transverse conductive fingers (41), the internal trenches being provided for connection to said conductive layer (7).

3. A method for manufacturing a vertical unipolar component in a semiconductor substrate, according to claim 1, **characterized in that** it comprises the steps of:
forming in the semiconductor substrate first trenches (40) spaced apart by a first distance (D) in the area corresponding to the actual unipolar component and second peripheral trenches (30) spaced apart by a second distance (d) shorter than the first distance (D) at the component periphery, and
performing a thermal oxidation so that a peripheral silicon oxide layer (3) forms between the first trenches and that the portions of the semiconductor substrate between the second trenches are completely oxidized into silicon oxide (33).

## Patentansprüche

1. Eine vertikale unipolare Komponente, gebildet in einem Halbleitersubstrat, die Folgendes aufweist: vertikale Finger (4), die aus einem leitenden Material bestehen, das mit Siliziumoxid (3) umgeben ist, Teile des Substrats (2), die vorhanden sind zwischen den Fingern und der Anordnung, die mit einer leitenden Schicht (7) beschichtet ist, **dadurch gekennzeichnet, dass** die Komponentenperipherie eine Folge mit Fingern (34-1 bis 34-5) aufweist, die in konzentrischen Gräben angeordnet sind, die voneinander nur durch Siliziumoxid (33) getrennt sind, wobei die obere Oberfläche der Finger von wenigstens des innersten Ranges (34-1) in Kontakt mit der leitenden Schicht ist.

2. Komponente nach Anspruch 1, **dadurch gekennzeichnet, dass** die internen Gräben von den konzentrischen Gräben durch erste transversale leitende Finger (40) untereinander verbunden sind und die externen Gräben auf ähnliche Weise durch zweite transversale leitende Finger (41) untereinander verbunden sind, wobei die internen Gräben zur Verbindung mit der leitenden Schicht (7) vorgesehen sind.

3. Ein Verfahren zum Herstellen einer vertikalen unipolaren Komponente in einem Halbleitersubstrat gemäß Anspruch 1, **dadurch gekennzeichnet, dass** es die folgenden Schritte aufweist:
Bilden, in dem Halbleitersubstrat, erster Gräben (40), die voneinander durch eine erste Distanz (D) in dem Gebiet, das der aktuellen unipolaren Komponente entspricht, beabstandet sind, und zweite periphere Gräben (30), die um eine zweite Distanz (d) beabstandet sind, die kleiner als die erste Distanz (D) ist, und zwar bei der Komponentenperipherie, und
Durchführen einer thermischen Oxidation, sodass eine periphere Siliziumoxidschicht (3) sich zwischen den ersten Gräben bildet und dass die Teile des Halbleitersubstrats zwischen den zweiten Gräben vollständig in Siliziumoxid (33) oxidiert sind.
